# FASCICULE DE BREVET EUROPEEN

(11) **EP 3 241 416 B1**
(45) Date de publication et mention de la délivrance du brevet: **03.05.2023**
(21) Numéro de dépôt: 15821097.1
(22) Date de dépôt: 30.12.2015
(51) Int. Cl.: H05K 3/14, C23C 4/18, C23C 24/04, C23C 4/129, C23C 4/02, C23C 4/08, C23C 28/02, H05K 1/05, H05K 1/16, H05K 3/22, H05K 3/46

(54) **STRUCTURE COMPORTANT DES LIGNES ÉLECTRIQUEMENT CONDUCTRICES EN SURFACE ET PROCÉDÉ POUR LA RÉALISATION DE LIGNES ÉLECTRIQUEMENT CONDUCTRICES SUR UNE FACE D'UNE STRUCTURE**
STRUKTUR MIT ELEKTRISCH LEITENDEN OBERFLÄCHENBAHNEN SOWIE VERFAHREN ZUR HERSTELLUNG VON ELEKTRISCH LEITENDEN BAHNEN AUF EINER OBERFLÄCHE EINER STRUKTUR
STRUCTURE COMPRISING ELECTRICALLY SURFACE CONDUCTIVE LINES AND METHOD FOR MAKING ELECTRICALLY CONDUCTIVE LINES ON A SURFACE OF A STRUCTURE

(30) Priorité: 30.12.2014 FR 1463440
(43) Date de publication de la demande: 08.11.2017
(73) Titulaire: Airbus Group SAS, 31700 Blagnac (FR); Mallard, 76170 Saint Antoine La Foret (FR)
(72) Inventeur: DANTIN, Benoît, 95170 Deuil La Barre (FR); LEMEILLE, Pascal, 27310 La Trinite De Thouberville (FR)
(74) Mandataire: Ipside
(86) Numéro de dépôt international: PCT/EP2015/081452
(87) Numéro de publication internationale: WO 2016/107918

(56) Documents cités:
- WO-A1-2012/136127
- US-A- 4 816 616
- US-A1- 2003 219 576
- US-A1- 2004 055 153
- US-A1- 2014 134 448
- US-B1- 6 640 434

## Description

L'invention appartient au domaine des structures incorporant des équipements électriques et nécessitant l'installation de lignes électriquement conductrices.

Une telle structure est par exemple celle d'un véhicule, par exemple la structure d'un aéronef.

Dans la plupart des structures, par exemple les structures des véhicules, il est de nos jours installé des équipements pour lesquels il est nécessaire d'agencer des lignes électriquement conductrices tant pour assurer une alimentation en énergie électrique de chaque équipement que pour transporter des signaux sous forme électrique de ou vers les équipements.

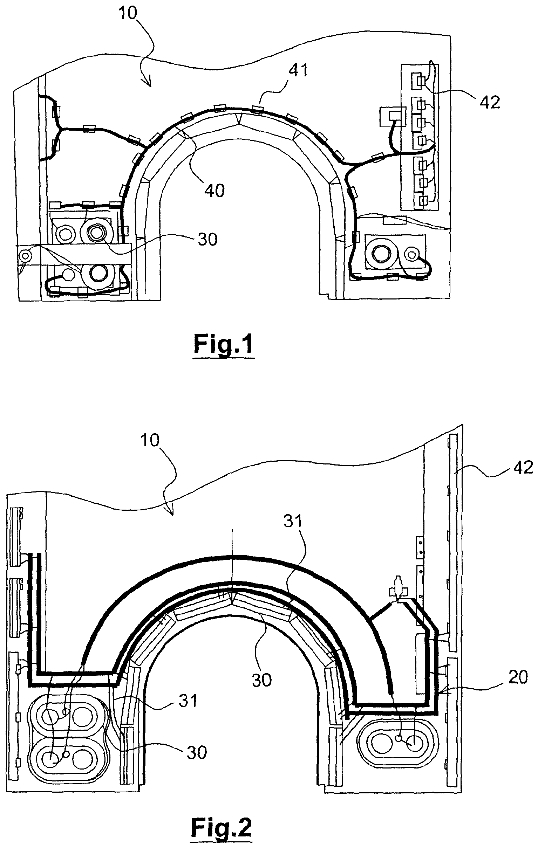

Une solution largement utilisée, illustrée sur la figure 1, consiste à fixer sur la structure 10 des faisceaux 40 de fils électriquement conducteurs reliant les différents points devant être mis en connexion électrique, par exemple reliant une barre de distribution d'énergie électrique 42 avec une borne d'alimentation d'un équipement 30 ou reliant les entrées et sorties de deux équipements distants devant échanger des informations.

Cette solution, qui sépare fonctionnellement la structure et les conducteurs électriques, présente l'inconvénient de mettre en oeuvre des fils nécessitant une isolation, qui pénalise la masse des liaisons électrique, et exige d'installer les fils sur des supports 41 ou dans des gaines pour diminuer le risque d'un endommagement de l'isolant par une usure en cas de frottement sur des parties de la structure, ce qui pénalise à nouveau la masse et également l'espace disponible délimité par la structure.

Il est également connu de disposer des pistes conductrices sur un substrat isolant pour former des circuits électriques comme dans l'exemple de la méthode décrite dans le document US 2011/0236566.

La méthode consiste à réaliser une piste conductrice sur un substrat isolant par la technique de la projection à froid d'un matériau métallique conducteur.

Toutefois cette solution ne permet de réaliser que des circuits relativement simples, lignes ou boucles, et nécessite que le substrat ne soit pas endommagé par le la projection à froid, mécaniquement agressive. En pratique la solution proposée n'est effectivement utilisable que sur des matériaux durs et isolants tel que du verre minéral.

Il est également connu d'intégrer des conducteurs dans une structure en matériau composite sous la forme de rubans ou de fils conducteur électriques qui sont intégrés en autant de couches que de besoins pour réaliser les alimentations électriques et les lignes de transport de signaux nécessaires aux différents équipements.

De telles solutions s'avèrent cependant complexes à mettre en oeuvre du fait qu'elles nécessitent que la définition des liaisons électriques soit parfaitement établie avant la réalisation de la structure et du fait qu'il est nécessaire de prévoir des raccordement électriques entre les conducteurs intégrés à chaque pièce d'un assemblage pour assurer la continuité électrique entre les pièces assemblées.

Lorsque des lignes électriques non prévues lors de la réalisation des pièces doivent être installées ou lorsque les pièces assemblées présentent des défauts de continuité de certaines lignes, l'impossibilité d'ajouter des lignes intégrées dans la structure conduit à l'installation de fils rapportés à l'extérieur de la structure avec les défauts déjà évoqués.

En outre l'intégration de rubans conducteurs dans une structure, par exemple entre des plis d'un matériau composite, introduit des perturbations de la structure qui sont susceptibles de nuire aux performances mécaniques de cette structure. Il est alors nécessaire de prévoir à la conception un surdimensionnement de la partie structurale pour prendre en compte cette diminution des performances.

Une telle solution n'est donc pas totalement satisfaisante, en particulier dans le cas de structures de grandes dimensions résultant d'un assemblage de plusieurs pièces.

Il est également connu, par exemple du document US2003/0219576, de réaliser des pistes en cuivre relativement épaisse de circuit imprimé sur un substrat isolant en réalisant une projection à froid sur une couche d'adhérence en argent déposé par une technique d'impression. Une telle solution n'est pas adaptée à la formation de pistes conductrices sur des structures de formes complexes en matériaux conducteurs ou en matériaux dont l'intégrité structurale doit impérativement être garantie à l'issue d'un dépôt par projection à froid qui en pratique s'avère agressif.

Le document US2004/0055153 décrit un procédé de fabrication d'une pièce moulée avec un chemin de conducteur intégré comportant une couche de germination appliquée sur le profil de la pièce.

Le document US6 640 434 divulgue un procédé de formation d'un circuit électrique sur une surface d'un substrat comprenant la fourniture d'un substrat ayant une surface avec au moins une rainure formée à l'intérieur, la rainure ayant une surface texturée inférieure, ainsi que l'application d'un matériau électriquement conducteur sur la surface texturée inférieure de la rainure.

Enfin, le document US 4 816 616 décrit un ensemble électrique comprenant un empilement de différentes couches permettant d'isoler des lignes de transmission référencées en tension.

La présente invention a pour objet de remédier à ces inconvénients en simplifiant l'installation électrique dans une structure tant dans sa conception que dans sa réalisation et dans la forme de l'installation obtenue.

L'invention concerne un procédé de réalisation d'une ligne électrique sur une surface d'une face d'une structure selon la revendication 1.

Il est ainsi formé, par un procédé de projection à la flamme relativement peu agressif pour la structure ou pour des couches inférieures, la couche de protection et d'accroche sur laquelle peut être déposée la couche conductrice et qui protège les couches inférieures des effets mécaniques de la projection à froid du matériau conducteur.

La couche isolante permet d'assurer une isolation électrique de la ligne réalisée dans le cas de structures conductrices électrique telles que des structures métalliques ou telles que des structures composites à fibres de carbone qui ne sont pas suffisamment isolante pour éviter la mise en oeuvre d'une couche isolante. La couche isolante permet également de protéger la structure lors de la mise en oeuvre des procédés de dépôt par projection à la flamme et de dépôt par projection à froid des couches supérieures. La couche isolante permet également de déposer la piste sur un support homogène même dans le cas de changements de matériaux de la structure et donc une meilleure maîtrise des procédés de dépôt des couches supérieures.

Dans un mode de mise en oeuvre, la couche isolante est réalisée par au moins un pli d'un tissu de fibres de verre ou de fibres d'un polymère électriquement isolant maintenues dans une matrice d'un polymère organique et fixée à la structure.

Dans un mode de mise en oeuvre, le matériau projeté par le procédé de projection à la flamme oxygaz pour former la couche de protection et d'accroche comporte principalement du Zinc, ou un alliage à base de Zinc, ou de l'Aluminium, ou un alliage à base d'Aluminium.

Avantageusement la couche de protection et d'accroche est formée avec une épaisseur comprise entre 0,05 mm et 1,5 mm.

Dans un mode de mise en oeuvre, pendant l'étape de réalisation de la couche de protection et d'accroche, la température de la flamme est comprise entre 200°C et 3000°C, avantageusement comprise entre 280°C et 1100°C.

Dans un mode de mise en oeuvre, le matériau projeté à froid pour former la couche conductrice électrique comporte principalement du cuivre, ou un alliage à base de cuivre.

Dans un mode de mise en oeuvre, le matériau projeté à froid pour former la couche conductrice électrique comporte principalement de l'aluminium ou un alliage à base aluminium.

Dans un mode de mise en oeuvre, la projection à froid du matériau projeté est réalisée avec des températures du gaz mis en oeuvre comprises entre 100 °C et 1100 °C, de préférence comprises entre 200 °C et 600°C et avec des pressions dudit gaz comprises entre 10 fois et 50 fois la pression atmosphérique standard, de préférence avec des pression comprises entre 18 fois et 45 fois la pression atmosphérique standard.

L'invention est décrite de manière détaillée en référence aux dessins qui représentent de manière schématique :
- la figure 1 : déjà citée, un exemple de structure comportant une installation électrique conventionnelle avec des câbles électriques et des supports de câbles ;
- la figure 2 : illustre un exemple d'installation électrique suivant l'invention pour une structure similaire à la structure de la figure 1 ;
- la figure 3 : une vue en perspective et en section d'un exemple simple de ligne suivant l'invention, la ligne étant représentée dans le cas simple d'une ligne rectiligne sur une structure plane ;
- la figure 4a : des représentations simplifiées en section d'exemples de cosses électriques rapportées sur la couche conductrice d'une piste, un exemple de cosse brasée et un exemple de cosse serrée ;
- la figure 4b : une représentation en vue perspective d'une ligne dans un exemple de zone de jonction de deux pièces d'une structure ;
- la figure 4c : une représentation en section d'un croisement de deux lignes sur une face de la structure ;
- les figures 4d et 4e : des représentations d'exemples de composants passifs réalisés sur une face de la structure suivant les principes de réalisation d'une ligne : figure 4d un exemple de résistances associées en parallèles et figure 4e un exemple d'inductance ;
- la figure 4f : une représentation simplifiée en section d'un défaut de la couche conductrice de la ligne réparé par un shunt brasé sur la couche ou réalisé par projection à froid d'un matériau conducteur ;

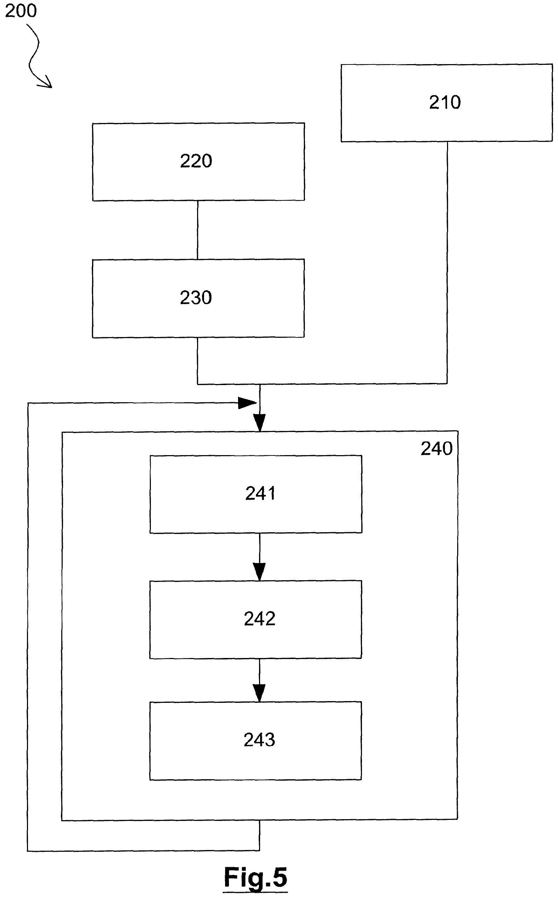

- la figure 5 : une représentation synoptique des étapes principales du procédé de l'invention.

Les figures sont des représentations schématiques de principes. Sur ces figures, les différentes parties ne sont pas nécessairement représentées à la même échelle, la compréhension de l'invention étant privilégiée plutôt que le réalisme des illustrations.

Sur les figures des éléments similaires par leurs structures ou leurs fonctions sont repérés par un même numéro même si ils présentent des formes différentes.

Par simplification, les lignes conductrices sont représentées rectilignes et sur des surfaces de structure plane. L'invention n'est pas limitée à cette forme de réalisation et les lignes conductrices peuvent suivre des trajectoires quelconques, courbes et ou anguleuses, à la surface de structures non planes pouvant présenter des surfaces courbées dans l'espace et pouvant présenter des formes complexes résultant d'assemblage de pièces.

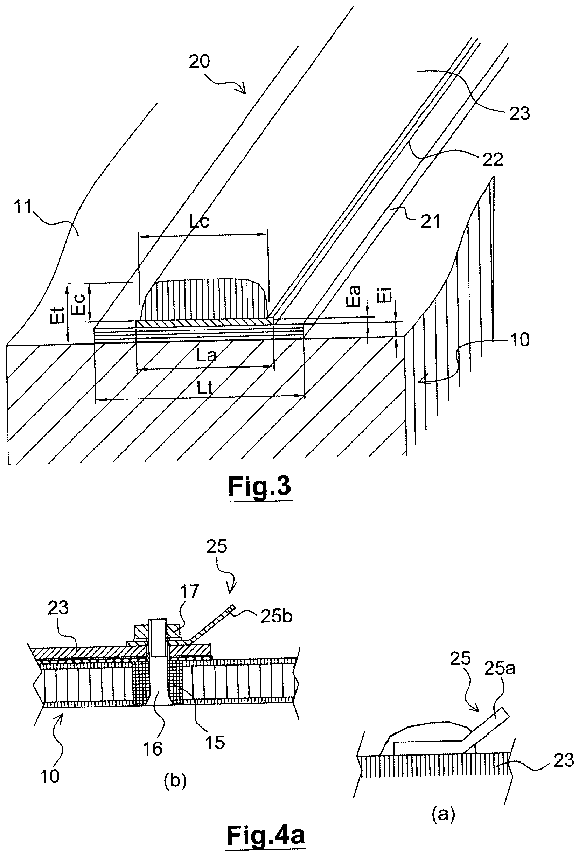

Bien que la pièce puisse présenter n'importe quelle orientation dans l'espace, il sera considéré dans la description des ordres et orientations correspondant à ceux de la figure 3.

Ainsi, dans la description, la structure 10 est considérée comme un élément inférieur et, dans un empilage d'éléments réalisé sur une surface 11 de ladite structure, une couche formée sur une autre couche est plus distante de la surface de la structure que cette autre couche, et au contraire elle est plus proche de la surface de la structure si elle est située sous l'autre couche, quelle que soit l'orientation de la pièce dans l'espace.

La figure 3 montre en vue perspective une partie d'une pièce de structure sur laquelle est formé un élément conducteur électrique réalisant des liaisons électriques entre des moyens de connexion 25.

Par simplification un élément conducteur électrique suivant l'invention sera désigné par le terme « ligne » 20 dans la suite de l'exposé, et les termes « conducteur » et « isolant », sauf indication ou évidence contraire, seront relatifs à la conduction électrique telle qu'elle est considérée dans le domaine des applications du transport des courants électriques pour l'alimentation en énergie ou pour la transmission de signaux.

Sur la figure 3, la ligne 20 est montrée en vue perspective, en coupe de sorte que les différents éléments constitutifs de la ligne sont visibles suivant l'agencement qu'ils ont dans ladite ligne de l'invention.

Dans l'exemple de la figure 2, la structure 10 supportant la ligne 20 est une structure appartenant à une partie structurale d'un véhicule, non représenté. Ladite structure peut être réalisée en tout ou partie dans un matériau présentant une faible résistivité comme le sont la plupart des métaux, par exemple des alliages d'aluminium, des aciers, des alliages de cuivre ....

Elle peut également être réalisée en tout ou partie dans un matériau présentant une résistivité relativement élevée sans entrer dans la catégorie des matériaux isolants, comme par exemple un matériau composite avec des fibres de carbone.

Elle peut également être réalisée en tout ou partie dans un matériau isolant comme par exemple un matériau composite comportant des fibres organiques, par exemple des fibres aramide, ou des fibres de verre, dans une matrice polymère isolante.

Dans la présente application, les matériaux considérés, dans le sens compris pour une installation électrique, comme conducteurs sont généralement ceux ayant une résistivité inférieure à 10⁻⁷ Ω.m et ceux considérés comme isolants sont généralement ceux présentant une résistivité supérieure à 10¹⁰ Ω.m, les matériaux entre ces deux valeurs étant généralement considéré comme faiblement conducteur.

A titre d'illustration, les fibres de carbone, considérées comme faiblement conductrices, ont des résistivités électriques généralement comprises entre 1,5×10⁻⁶ Ω.m et 1,5×10⁻⁵ Ω.m.

La ligne 20 de la figure 2 présente une largeur totale **Lt** et une épaisseur totale **Et.**

Dans l'exemple illustré, la ligne comporte trois couches superposées : une première couche 21 isolante déposée au contact de la surface 11 de la pièce, une deuxième couche 22 de protection et d'accroche formée sur la première couche, et une troisième couche 23 conductrice formée sur la couche de protection et d'accroche.

La ligne 20 est donc formée par des bandes superposées correspondant aux différentes couches, les dites bandes suivant un trajet de la ligne sur toute une longueur de ladite ligne.

La première couche 21 isolante est constituée par un matériau isolant et présentant des propriétés mécaniques lui permettant d'accompagner les déformations de la structure 10 en service sans être endommagée, en particulier sans rupture et sans décollement de ladite première couche isolante.

Dans une forme de réalisation, la première couche 21 est formée principalement avec un ou plusieurs plis de fibres de verre imprégnées d'une résine polymérisée, résine choisie en fonction du matériau de la pièce pour assurer une parfaite adhérence, avec ou sans la mise en oeuvre d'un adhésif intercalaire. Il est connu des résines qui assurent une bonne adhérence par exemple sur des alliages d'aluminium, par exemple des résines époxyde. Lorsque la pièce 10 est formée dans un matériau composite comportant des fibres organiques ou minérales, maintenues dans une résine, la résine mise en oeuvre pour les plis de verre de la première couche 21 est avantageusement une résine compatible avec la résine de la pièce et pouvant adhérer lors d'une polymérisation au contact de ladite pièce.

Comme il sera compris de la suite de la description et de la mise en oeuvre du procédé de réalisation, la première couche 21 isolante est réalisée dans un matériau résistant à un dépôt de matériau par projection à la flamme dit oxygaz.

Un tel procédé de dépôt est connu et relativement ancien.

Il présente la propriété de pouvoir être mis en oeuvre avec des énergies cinétiques relativement faibles du fait que le matériau apporté est déposé dans une phase liquide, ou au moins dans un état pâteux, du fait de son échauffement dans la flamme.

Il permet ainsi un bon accrochage du matériau déposé et, comme expliqué ultérieurement, sous réserve de choix de paramètres adaptés du procédé, de ne pas endommager le substrat formé par la première couche 21 isolante et par le matériau de la structure 10.

La première couche 21 isolante est par exemple rapportée sur la surface 11 de la pièce 10 par collage.

Dans le cas d'une pièce en matériau composite devant constituer la structure ou devant entrer dans un assemblage de la structure, ladite première couche peut être le résultat d'un processus d'adhérence lors de la fabrication de la pièce, par exemple par cocuisson des résines de la pièce et de la première couche 21 isolante.

La première couche 21 isolante n'a pas ici de vocation à renforcer la structure de la pièce bien que cette possibilité puisse être prise en compte dans la conception de la structure et, par définition du fait de son caractère isolant, ne participe pas à la conduction électrique de la ligne 20.

Une épaisseur **Ei** de la première couche 21 isolante sera donc choisie aussi mince que possible, pour en minimiser la pénalité de masse en particulier.

L'épaisseur **Ei** sera cependant suffisante pour apporter au support formé par la première couche 21 isolante la résistance mécanique attendue et pour assurer l'isolation électrique recherchée en prenant en compte les imperfections possibles de sa réalisation, en particulier en considération des différences de potentiel électrique entre la partie électriquement conductrice de la ligne et la structure lorsque celle-ci est conductrice ou n'est pas considérée comme suffisamment isolante, de sorte à éviter des claquages électriques en utilisation.

Dans le cadre d'une application à une structure d'un véhicule, par exemple un aéronef, l'épaisseur **Ei** de la première couche 21 isolante est comprise avantageusement entre 0,2 mm et 1 mm.

Dans l'exemple de réalisation de la figure 3, la première couche isolante forme une bande isolante dont la largeur correspond à la largeur totale **Lt** de la ligne 20.

La deuxième couche 22 de protection et d'accroche, déposée sur la première couche 21 isolante, a pour fonction de permettre un accrochage de la troisième couche 23 conductrice et également de former une protection des couches inférieures pendant les opérations de dépôt d'un matériau conducteur formant ladite troisième couche conductrice.

La deuxième couche 22 de protection et d'accroche est ici une couche comportant principalement de zinc ou d'aluminium, purs ou alliés, qui est déposé par projection à la flamme, avec une épaisseur **Ea** faible, comprise entre 0,05 mm et 1,5 mm.

La deuxième couche 22 de protection et d'accroche présente une largeur **La,** qui est inférieure à la largeur **Lt** et qui est avantageusement plus ou moins centrée sur la bande formée par la première couche 21 isolante, de sorte que ladite deuxième couche de protection et d'accroche ne soit pas en contact direct avec la structure 10, en particulier dans le cas d'une structure réalisée avec des matériaux non isolants.

Le matériau formant la seconde couche 22 de protection et d'accroche est déposé pour former une bande continue par un procédé de dépôt de matériau par projection à la flamme oxygaz.

Dans le cas présent, les paramètres pour l'application du procédé de dépôt à la flamme, en particulier : matériau déposé, température, vitesse de projection, sont choisis afin de former la deuxième couche 22 de protection et d'accroche sans endommager la première couche 21 isolante et sans endommager le matériau de la structure 10, comme il sera précisé dans le procédé de l'invention.

La troisième couche 23 conductrice est une couche métallique comportant principalement du cuivre ou un alliage à base de cuivre, ou de l'aluminium ou un alliage à base d'aluminium.

D'autres matériaux conducteurs électriques, purs ou sous forme d'alliages, peuvent être utilisés pour former la troisième couche conductrice, sous réserve qu'elle puisse être déposée comme décrit dans le procédé avec une énergie au niveau de la surface sur laquelle est déposé le matériau de ladite troisième couche sans endommager les couches inférieures.

La troisième couche 23 conductrice assure dans la ligne 20 le passage du courant électrique avec l'intensité souhaitée.

Le matériau conducteur utilisé pour former la troisième couche conductrice est déposé suivant un procédé de projection à froid.

Dans le cas de l'invention, le procédé de projection à froid, connu en lui même, est avantageusement mis en oeuvre, pour obtenir les performances mécaniques et électriques souhaitées de la troisième couche, avec une énergie minimale pour éviter de détériorer les couches inférieures de la ligne 20 et le matériau de la structure 10.

Le procédé de projection à froid présente dans le cas de la présente invention plusieurs avantages pour la réalisation d'un dépôt du matériau conducteur pour former une ligne.

En particulier la troisième couche 23 peut être réalisée avec des largeurs et des épaisseurs très différentes et donc permet de former des lignes pour conduire une large gamme d'intensités des courants.

En pratique, une épaisseur **Ec** et une largeur **Le** de ladite troisième couche, déterminent une section conductrice de la ligne, fonction d'une intensité maximale du courant électrique devant être conduit par la ligne 20, ainsi que de la résistivité du matériau conducteur utilisé et de sa longueur pour tenir compte des pertes de charge comme dans toute installation électrique.

La troisième couche 23 conductrice se superpose sensiblement à la seconde couche 22 de protection et d'accroche avec laquelle seconde couche de protection et d'accroche elle présente de préférence une largeur égale ou légèrement inférieure pour bénéficier d'une surface d'accrochage maximale.

En fonction des besoins de passage en intensité du courant électrique, une épaisseur **Ec** de la troisième couche conductrice est comprise entre environ un dixième de millimètre et plusieurs millimètres, en pratique jusqu'à au moins 10 millimètres pour des applications courantes.

Par exemple, lorsque la ligne est destinée à conduire des courants faibles, comme dans le cas de la transmissions de signaux électriques, analogiques ou numériques, un fil conventionnel de jauge 30 suivant la normalisation AWG, de 0,05 mm² de section conductrice, est avantageusement remplacé par une ligne avec une troisième couche conductrice de 0,5mm de largeur et de 0,1 mm d'épaisseur que permet de réaliser le procédé de l'invention.

A contrario, lorsque la ligne est destinée à transporter des courants élevés, par exemple correspondant à l'utilisation de fils conventionnels de jauge 10 ou moins suivant la normalisation AWG, correspondant à des sections de 5 mm² ou plus, la ligne sera avantageusement formées avec des épaisseurs de la troisième couche conductrice pouvant atteindre ou dépasser 8 mm avec des largeurs par exemple comprises entre 1 mm et des largeurs en théorie non limitée.

Par exemple une ligne de section conductrice de 80 mm² avec une largeur de 10 mm et une épaisseur de 8 mm, c'est-à-dire sensiblement une jauge 3/0 suivant la normalisation AWG, est en mesure d'alimenter des équipements fortement consommateurs en courant tels que des actionneurs électriques de puissance.

Une largeur conductrice de la ligne, en ce qu'elle est déterminée par la largeur **Lc** de la troisième couche conductrice, n'est pas contrainte par les principes de l'invention et peut donc être très variable suivant les besoins d'installation de la ligne considérée.

En pratique le concepteur déterminera, suivant ses contraintes d'installation électrique, en particulier les dimensions de la structure et un nombre de lignes devant cheminer sur la surface 11 de la structure, pour chaque ligne un rapport qu'il donnera entre la largeur **Le** conductrice et l'épaisseur **Ec** conductrice pour obtenir la section conductrice souhaitée pour la ligne.

Il doit être noté ici que pour une section conductrice donnée, ce rapport n'est pas nécessairement constant sur toute une longueur de la ligne 20, en particulier pour répondre à des contraintes d'installation des lignes.

Dans l'exemple d'une ligne suivant l'invention qui vient d'être décrit il est considéré le cas d'une ligne isolée.

Dans la plupart des cas d'une installation électrique complexe, il sera généralement formé plusieurs lignes sur la surface 11 de la structure 10 comme dans l'exemple de la figure 2. Dans ce cas, une même première couche isolante peut être réalisée pour supporter plusieurs secondes couches de protection et d'accroche et troisième couches conductrices, avantageusement dans le cas de lignes proches l'une de l'autre. Dans un tel mode de réalisation, la largeur de ligne **Lt** considérée dans la description sera avantageusement interprétée comme la largeur prenant en compte une largeur de la première couche 21 isolante affectée à une ligne considérée.

Dans ce cas la première couche isolante a nécessairement une largeur suffisante pour déposer les autres couches de lignes sans risque d'interférence entre les deuxièmes et troisièmes couches.

Dans une forme particulière de réalisation, une couche isolante est déposée sur toute la surface de la pièce de sorte que les deuxièmes et troisièmes couches peuvent être déposées sans contrainte vis à vis de la question de l'isolation électrique par rapport à la structure.

Dans ce dernier cas, le dépôt d'une première couche isolante complémentaire peut s'avérer nécessaire en des zones de jonctions de pièces de la structure du fait d'assemblages qui ne sont pas nécessairement protégées par la couche isolante rapportée à la surface de pièces lors de leur réalisation avant assemblage pour former la structure.

Dans une forme de réalisation, la structure est réalisée dans un matériau électriquement isolant et la ligne de l'invention est formée sans la première couche isolante dont la fonction est alors assurée par la structure elle même.

Toutefois, même dans le cas d'une structure formée dans un matériau isolant, il pourra être préféré mettre en oeuvre une première couche 21 isolante qui assurera une protection de la structure lors de la réalisation des deuxième et troisième couches de la ligne au moment de la réalisation de ladite ligne et qui assurera également des fonctions de protection de la structure en cas d'intervention pour réparer la ligne 20, voire pour retirer de la surface 11 de la structure, par exemple par abrasion ou usinage, tout ou partie de la ligne dans le cas d'une réparation ou d'une modification de la définition de l'installation électrique.

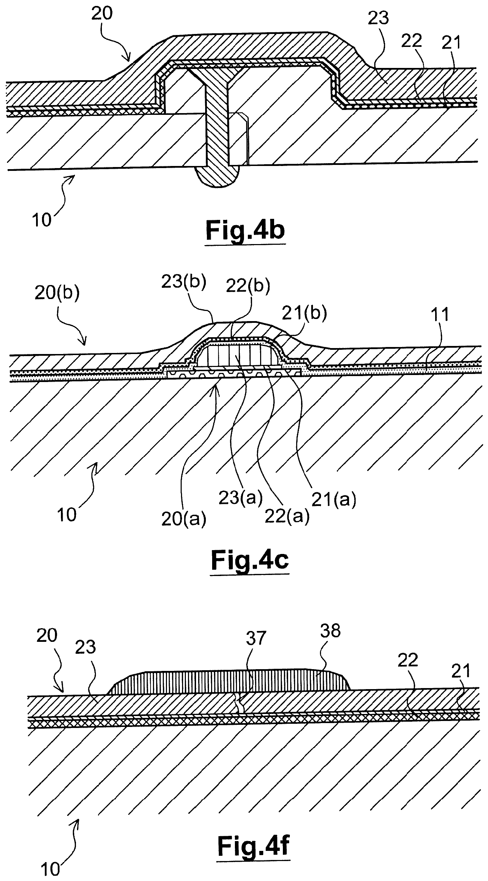

Il doit également être compris que l'invention permet de réaliser des lignes se croisant sur la face 11 de la pièce. Un croisement est rendu possible par la première couche isolante qui est déposée par dessus une ligne déjà formée avant de déposer les autres couches d'une autre ligne croisant la ligne déjà formée et permet d'assurer l'isolement électrique entre les deux lignes distinguées sur l'illustration de la figure 4c par les indices (a) et (b).

On comprend donc ici que des installations électriques complexes comportant une pluralité de lignes peuvent être agencées sur une face d'une structure, pour autant que ladite face soit accessible pour permettre de former les dites lignes avec les moyens mis en oeuvre.

Dans une forme de réalisation, un isolant, avantageusement sous la forme d'une résine ou d'une peinture, est déposé sur les lignes 20 réalisées pour créer une couche électriquement isolante assurant à la fois une protection des personnes pouvant se trouver mise en contact avec des parties conductrices des lignes et assurant une protection contre les courts circuits en cas de contact de la structure avec des objets conducteurs et assurant également une protection des matériaux conducteurs des lignes vis à vis des agressions extérieures, en particulier l'oxydation et potentielles autres attaques chimiques.

Dans une forme préférée, cette couche de protection est transparente de sorte que des défauts, par exemple une rupture de la troisième couche 23 conductrice, puisse être détectée ou recherchée visuellement.

La mise en oeuvre d'une couche de protection transparente aux rayonnements infrarouges permet également de détecter, en réalisant un examen au moyen d'une caméra thermique, un défaut de conduction qui dans de nombreux cas se traduit par un échauffement local en raison une résistance électrique accrue à l'emplacement du défaut.

Une telle inspection peut également être réalisée dans le cadre d'un contrôle de la qualité des lignes lors de la fabrication des dites lignes et de la structure pour compléter les tests de continuité et d'isolement généralement pratiqués sur les installations électriques conventionnelles.

Dans une forme de réalisation, comme illustré dans les exemples sur la figure 4a, une ligne 20 comporte des moyens de connexion 25, par exemple des cosses 25a, 25b ou des bornes électriques, fixés à la troisième couche 23 conductrice, par exemple par brasage, comme sur le détail (a) de la figure 4a, lorsque la ligne est réalisée ou par intégration à la troisième couche 23 lors de la réalisation de ladite troisième couche, en assurant la continuité électrique entre la dite troisième couche conductrice et chaque élément de connexion.

De tels moyens de connexion 25 sont agencés en tout point de la ligne 20 où il est prévu de raccorder, par une ligne électrique conventionnelle 31, un équipement électrique 30 ou pour assurer une continuité électrique avec une partie de l'installation électrique soit conforme à l'invention mais sur autre partie de structure soit réalisée suivant une architecture conventionnelle. Il doit être noté que des moyens de connexion surnuméraires peuvent être disponibles sur une ligne 20 en provision, par exemple pour l'installation de nouveaux équipements ou pour répondre à des solutions de réparation.

Des moyens de connexion 25 peuvent être fixés à une extrémité de ligne 20 ou en tout emplacement entre des extrémités de ladite ligne.

Les moyens de connexion peuvent en pratique être fixés par tout dispositif permettant un raccordement assurant une continuité électrique.

Des moyens de connexion peuvent consister en une cosse maintenue sur la troisième couche 23 conductrice par brasage ou par intégration dans la troisième couche comme déjà précisé.

Des moyens de connexion peuvent également consister en des moyens de raccordement tel qu'un ensemble de bornes électriques qui est par exemple fixé sur la structure en maintenant le contact électrique nécessaire avec la troisième couche 23 conductrice, cas non illustré.

Des moyens de connexion peuvent également consister, comme illustré sur le détail (b) de la figure 4a, en un trou réalisé dans la structure 10 et traversant la troisième couche 23 conductrice de sorte qu'il puisse être placé une vis 16 pour serrer avec un écrou 17, contre ladite troisième couche conductrice, une cosse à anneau 25b, élément de terminaison d'un conducteur électrique conventionnel. Dans ce cas, avantageusement la troisième couche 23 présente une surface suffisante, au besoin par une forme localement élargie par rapport à la largeur conductrice Le courante, pour former une surface d'appui de la cosse serrée.

Dans le cas d'une structure 10 en matériau composite, il pourra être considéré de placer, dans la dite structure composite à l'emplacement prévu d'une connexion, un insert 15 comportant le trou recevant la vis 16 pour le serrage de la cosse 25b, soit que le trou de l'insert est un trou taraudé pour accueillir la vis de serrage de la cosse, soit que l'insert forme, comme présenté sur le détail (b) de la figure 4a dans le cas d'une structure de type sandwich à âme alvéolaire, un trou traversant évitant de percer la structure composite et évitant de réaliser un serrage direct sur la structure composite.

Un tel insert peut être réalisé dans un matériau conducteur et il sera dans ce cas déposé les différentes couches de la ligne pour garantir une continuité électrique entre l'insert et la troisième couche conductrice.

Dans une forme de mise en oeuvre, un tel insert conducteur, lorsqu'il traverse la structure, assure une liaison électrique entre des faces opposées de ladite structure.

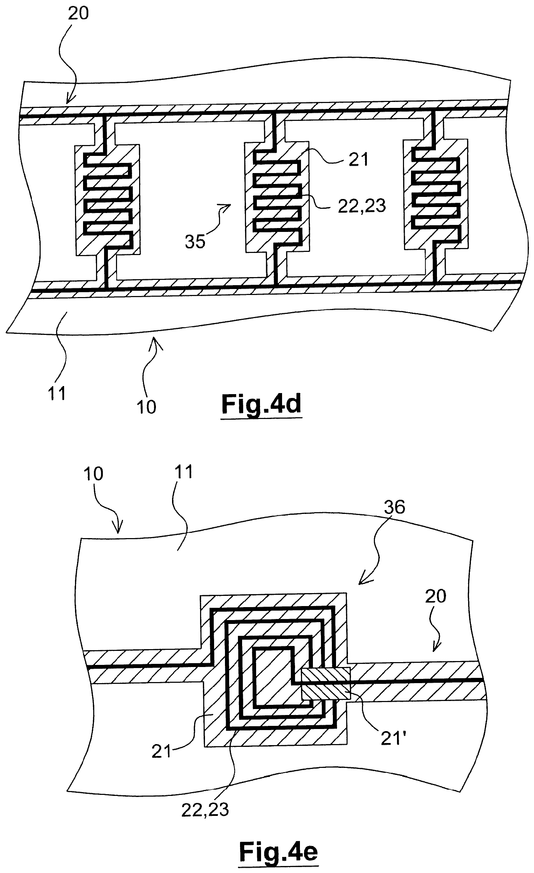

Bien qu'il soit précédemment considéré des lignes électriques pour le transport de courants de puissances ou de signaux, les secondes et troisième couches peuvent correspondre à des motifs plus ou moins complexes pour constituer, sur une ligne ou un ensemble de lignes, des composants électriques passifs, par exemple des inductances 36, des éléments rayonnant ou des résistances 35, comme illustré sur les détails des figures 4d et 4e, et de manière générale tout type de composant passif susceptible d'être réalisé par des lignes ou des surfaces conductrices.

La figure 4d illustre un exemple de résistances 35, montées en parallèle dans l'exemple, et pouvant être utilisées comme moyen de chauffage par exemple pour réaliser des fonctions de dégivrage d'une structure.

La figure 4e illustre un exemple d'inductance 36 réalisée sous la forme d'une bobine plate.

Dans ces deux exemples, les composants sont réalisés au moyen de lignes 20 conformes à l'invention et présentant les caractéristiques adaptées à l'application considérée, en particulier de résistance électrique pour ce qui concerne les résistances et de géométrie pour ce qui concerne les inductances.

Dans les exemples de réalisation de composants illustrés sur les figures 4d et 4e, la première couche 21 isolante est réalisée sous la forme d'une surface couverte de la structure sensiblement rectangulaire pour supporter les deuxième et troisième couches formant le composant. Lorsque le motif réalisé par les couches conductrices conduit localement à une superposition non souhaitées de dépôt de matériau conducteur, il est, comme dans l'exemple illustré sur la figure 4e, déposé une première couche 21' isolante.

Ces possibilités permettent de réaliser par exemple des antennes radioélectriques, des capteurs divers, des éléments chauffants de systèmes de dégivrage directement intégrés sur une face de la structure.

L'invention concerne également un procédé 200 pour réaliser une structure 10 comportant une ou plusieurs lignes 20 électriquement conductrices déposées sur une face 11 de ladite structure pour former des liaisons électriques entre des moyens de connexion 25 pour raccorder des équipements 30 et ou des fils conducteurs 31 électriques.

Suivant un mode de réalisation préféré, dans une première étape 210, une structure 10 ou une partie de structure, par exemple une structure d'un véhicule, est réalisée de manière conventionnelle, au moins dans le cas d'une structure complexe comme celle d'un véhicule tel qu'un aéronef, par un assemblage de pièces élémentaires.

Une pièce élémentaire peut être constituée de tout matériau ou assemblage de matériaux électriquement isolants et ou électriquement conducteurs, ladite pièce étant conçue pour répondre en priorité aux exigences structurales de la structure dans laquelle elle est intégrée.

Une pièce peut être principalement métallique, par exemple en un alliage à base d'aluminium, en un acier, en un alliage à base de titane ...

Une pièce peut également être principalement en matériau composite, par exemple comportant des fibres minérales ou organiques maintenues dans une matrice polymère.

Dans une seconde étape 220, associée à la conception du véhicule, il est défini sur au moins une face 11 de la structure 10, ou de la partie de structure, la position des moyens de connexion 25 devant être électriquement reliés par une ligne 20 conductrice et, associé aux dits moyens de connexion, les performances électriques, principalement les courants électriques conduits et les tensions électriques appliquées, qui doivent être considérés.

L'homme du métier comprend ici que, par courant et tension, il doit prendre en compte, comme dans la conception de toute installation électrique, les différentes conditions susceptibles de conduire à un dimensionnement particulier d'une ligne électrique, par exemple les valeurs nominales ou maximales continues, les valeurs de court circuit ...

Dans une troisième étape 230, il est défini un cheminement, sur la ou les faces 11 de la structure 10, pour chaque ligne 20 reliant des emplacements des différents moyens de connexion 25 de la ligne considérée.

Dans cette troisième étape il sera mis en oeuvre les méthodes conventionnelles de conception des installations électriques en y ajoutant la contrainte que les lignes 20 sont formées sur la face de la structure qui dans le cas le plus général forme une surface non plane.

Cette contrainte conduit à prendre en compte d'une part que l'installation est principalement bidimensionnelle alors que dans une conception conventionnelle il est possible d'exploiter une troisième dimension de l'espace en éloignant plus ou moins les lignes de la structure et d'autre part des discontinuités éventuelles de la structure pouvant conduire à dévier des trajets de lignes pour des raisons de faciliter de réalisation ou de réparation d'une ligne, ou pour éviter des risques d'endommagement d'une ligne en exploitation.

Il doit être considéré à ce titre que la réalisation d'une ligne 20 met en oeuvre des moyens plus ou moins volumineux et lourds et que les lignes doivent être formées avec une précision généralement de l'ordre du millimètre, voire moins, et que l'homme du métier doit prendre en compte la mise en oeuvre de ces moyens dans la structure considérée.

Dans cette troisième étape, il est également défini les caractéristiques géométriques de la ligne qui prennent en compte les performances électriques attendues et les contraintes d'installation.

Ainsi il est déterminé une largeur totale **Lt** de la ligne 20, une largeur **Le** d'une bande conductrice de la ligne et une épaisseur **Ec** de ladite bande conductrice.

Le couple largeur **Le** et épaisseur **Ec** de la bande conductrice est choisi pour obtenir la surface voulue de la section électriquement conductrice.

La largeur totale **Lt** de la ligne, qui correspond à celle d'un support isolant de la partie conductrice de la ligne 20, résulte du choix de la largeur **Le** de la bande conductrice et de la nécessité que ladite bande conductrice ne déborde pas latéralement dudit support isolant. Avantageusement **Lt** est supérieure à **Le** d'un minimum de un millimètre.

Il doit être remarqué que la largeur totale **Lt**, la largeur de la bande conductrice **Le** et l'épaisseur de la bande conductrice **Ec** ne sont pas nécessairement constant et peuvent être différents suivant un emplacement considéré d'une longueur de la ligne 20.

Ces largeurs et épaisseurs qui correspondent à des dimensions transversales de la ligne 20 peuvent évoluer par exemple, à performance constante, en fonction de contraintes géométriques locales imposées par la structure 10, et ou en fonction d'exigences de performances variables lorsqu'une ligne 20 est utilisée par exemple pour alimenter plusieurs équipements répartis le long de ladite ligne et que, en conséquence, le courant maximum dans la ligne diminue en fonction du nombre d'équipements restant en aval d'un point considéré de ladite ligne.

Lorsque que les différentes données nécessaires à la réalisation d'une ligne 20 sont établies, ladite ligne est réalisée dans une quatrième étape 240, sur la surface correspondant à la face 11 de la structure 10 sur laquelle doit être formée la ligne, par le dépôt successif de trois couches superposées.

Dans une première sous-étape 241 de cette quatrième étape, il est déposé une première couche isolante 21 sur la structure.

Ladite couche isolante se présente par exemple sous la forme d'un ruban de largeur **Lt** adhérant à la surface de la face 11 en suivant le trajet défini pour la ligne 20 sur ladite surface.

Outre sa caractéristique d'isolant électrique, le matériau mis en oeuvre pour former la couche isolante 21 doit pouvoir être fixé à la structure, avec une tenue permettant de garantir la qualité de l'adhérence dans les conditions d'environnement, et pour au moins la durée d'utilisation, de la structure. Il doit également être compatible avec le matériau de la structure.

De plus, il doit permettre la mise en oeuvre du procédé pour déposer la deuxième couche de protection et d'accroche 22 devant supporter la troisième couche conductrice 23 et doit également supporter les conditions imposées par le procédé de dépôt de ladite troisième couche, dont les conditions sont détaillées ci-après.

Lorsque le matériau de la structure est compatible, la première couche isolante 21 peut être formée dans un matériau céramique.

Dans une forme avantageuse, la première couche isolante 21 est formée en déposant une bande formée d'un ou plusieurs plis de fibres de verre ou de fibres polymères imprégnées d'une matrice polymère et maintenue par collage.

Le dépôt peut être réalisé par tout procédé connu d'apport d'une couche d'un matériau composite sur une structure constituée, le cas échéant d'une structure en cours d'élaboration. Avantageusement la bande est déposée par un robot qui applique la dite bande sous la forme d'un ruban déroulé le long de la trajectoire souhaitée en appliquant les conditions de pression et de température adaptées à un adhésif mis en oeuvre pour obtenir l'adhérence.

Dans un mode de mise en oeuvre, la première couche isolante 21 est déposée sous la forme de fibres imprégnées d'une résine non polymérisée et soumises, après avoir été déposée avec les conditions de pression adaptées, à une polymérisation qui provoque simultanément le durcissement de la résine, et donc de la première couche, et l'adhérence de ladite première couche sur la structure. La polymérisation est réalisée en fonction des caractéristiques de la résine. Il peut s'agir par exemple d'une polymérisation à température ambiante sous l'effet d'un catalyseur de la résine, d'une polymérisation par application d'une cuisson thermique, d'une photopolymérisation obtenue par application d'un rayonnement lumineux, ultraviolet en général, ou de toutes autres conditions applicables à la résine et adaptées à l'environnement de la structure.

L'épaisseur **Ei** de la première couche 21 isolante est par exemple comprise entre 0,2 mm et 1 mm, épaisseur suffisante en regard des tensions utilisées par exemple dans un aéronef, qui correspond en pratique à un ou deux plis d'un tissus de fibres de verre tissées.

Dans une deuxième sous étape 242 de la quatrième étape, une deuxième couche 22 de protection et d'accroche est déposée par dessus la première couche 21 isolante.

La deuxième couche 22 de protection et d'accroche consiste en un dépôt métallique comportant principalement du zinc ou de l'Aluminium par un procédé de projection à la flamme.

Le procédé de projection à la flamme est connu en lui-même. Il consiste à amener un produit à déposer à une température de fusion par la combustion d'un mélange d'oxygène avec un gaz combustible pour former une flamme dite « oxygaz » et à projeter le produit fondu à l'emplacement souhaité par un fluide de propulsion, par exemple un gaz comprimé tel que de l'air ou un gaz neutre.

Dans le cas présent, il doit être formée une couche mince d'un matériau qui assure la protection de la couche isolante et de la structure lors de l'application du procédé de dépôt du matériau de la troisième couche conductrice 23.

Dans le cas présent, la première couche isolante 21 est relativement fragile et sensible aux agressions thermiques et aux agressions mécaniques.

Il est en conséquence mis en oeuvre le procédé de projection à la flamme avec des conditions d'énergie minimale pour ne pas dégrader sensiblement la première couche 21 isolante sur laquelle est déposée la deuxième couche 22. Ainsi il est mis en oeuvre du zinc ou de l'aluminium ou des alliages utilisant un de ces matériaux comme composant principal qui sont peu exigeants en énergie pour être portés à une température de ramollissement et être projetés.

En pratique d'autres métaux ou alliages présentant des caractéristiques similaires peuvent être utilisés pour former la deuxième couche. Ils devront toutefois présenter une dureté à froid suffisante pour supporter le procédé du dépôt de la troisième couche et devront également respecter les contraintes liées aux spécifications d'environnement pour l'utilisation prévue, en particulier en termes de toxicité et d'inflammabilité.

Une température de la flamme est comprise entre 200°C et 3000°C, de préférence entre 280°C et 1100°C, et le matériau est projeté avec une vitesse comprise entre 20 m/s et 100 m/s, de préférence entre 25 m/s et 70 m/s.

La deuxième couche de protection et d'accroche est de préférence relativement mince, une épaisseur comprise entre 0,05 mm et 1,5 mm ayant montré qu'elle est suffisante pour les applications considérées à apporter les propriétés d'accrochage et de protection recherchées.

L'épaisseur et la largeur souhaitées pour la deuxième couche 22 de protection et d'accroche son obtenues par des formes de buses de projection, par un réglage des paramètres du procédé tel que le débit du matériau déposé, ainsi que d'une avance de la buse de projection et le nombre de passes le cas échéant.

Avantageusement le déplacement et l'orientation de la buse par un robot permet de suivre précisément la trajectoire correspondant à la ligne 20 à réaliser et d'obtenir des caractéristiques sensiblement constantes le long de la dite ligne, résultat qu'il serait difficile d'obtenir par un déplacement manuel de la buse, même si un déplacement manuel n'est pas exclu, en particulier dans le cas de procédures de réparations.

Dans une troisième sous-étape 243 de la quatrième étape, une troisième couche 23 conductrice est déposée par dessus la deuxième couche 22 de protection et d'accroche, sans déborder sensiblement de ladite deuxième couche de protection et d'accroche.

La troisième couche 23 consiste en un dépôt métallique comportant principalement du Cuivre ou un alliage à base de cuivre, ou de l'Aluminium ou un alliage à base d'aluminium par un procédé de projection à froid.

Le procédé de projection à froid est connu. Il s'agit d'un procédé de métallisation dans lequel des particules métalliques sont projetées à vitesse élevée, des vitesses supérieures à 800 m/s étant couramment mises en oeuvre dans ce procédé, par un gaz sous pression sur la pièce, la force d'impact réalisant le soudage à froid du matériau métallique projeté sous l'effet mécanique des impacts, assurant ainsi la qualité du dépôt.

Les avantages du procédé de projection à froid sont connus, en particulier une bonne cohésion avec la surface soumise à la projection, une faible porosité du matériau déposé, un niveau d'oxydation réduit du fait de la température modérée à laquelle est porté le matériau métallique, de faibles tensions internes du matériau déposé du fait d'un niveau de rétreint limité pour les mêmes raisons de température modérée, une précision du dépôt sur les zones traitées qui permet de réaliser des motifs relativement fins sans mettre en oeuvre de masque physiques.

Il permet également d'atteindre des épaisseurs de plusieurs millimètres en conservant ces qualités.

Contrairement au procédé de projection à la flamme, le procédé de projection à froid, qui permet d'atteindre des épaisseurs de métal déposé compatibles avec la réalisation des lignes électriquement conductrices recherchées, est relativement agressif sur le plan mécanique et est susceptible de détériorer le matériau isolant en fibres de verre et matrice polymère de la première couche 21, et le matériau de la structure en particulier lorsqu'il n'est pas métallique.

Dans le procédé de l'invention, la mise en oeuvre de ce procédé de projection à froid, qui permet de réaliser la troisième couche 23, est cependant possible par la réalisation préalable de la deuxième couche 22 de protection et d'accroche qui protège la première couche isolante de l'agression directe de la projection à froid.

Malgré cette couche de protection et d'accroche, il est pris précaution pour la mise en oeuvre de cette troisième sous-étape de ne pas concentrer des flux d'énergie trop longtemps sur une même zone de la structure, et le dépôt par projection à froid lors de cette troisième sous-étape est réalisé autant que de besoin par passes multiples pour atteindre la largeur et l'épaisseur souhaitée pour la troisième couche conductrice.

Les conditions de la projection à froid seront également ajustées pour limiter au maximum le flux l'énergie supporté par la deuxième couche 22 et les couches sous-jacentes tout en garantissant la formation du conducteur formé par le matériau projeté.

Une température du gaz est comprise entre 100°C et 1100°C, de préférence entre 200°C et 600°C, et une pression du gaz est comprise entre 10 fois et 50 fois la pression atmosphérique standard, de préférence entre 18 fois et 45 fois la pression atmosphérique standard.

Comme dans le cas de la première couche isolante et de la deuxième couche de protection et d'accroche, il sera préféré mettre en oeuvre un robot pour déplacer la tête de projection à froid et assurer la précision et l'homogénéité du dépôt.

La quatrième étape 240 est bien évidemment réalisée pour chacune des lignes devant être formées sur la face 11 de la structure 10 jusqu'à avoir créé le réseau électrique défini lors des étapes deux 220 et trois 230 du procédé, étapes qui sont a priori réalisées avant la première étape 210, lors de la conception du véhicule, et peuvent aboutir à une définition du réseau électrique suivant l'invention commune, au moins en partie, à une famille de véhicules d'un même modèle.

Comme déjà signalé, le procédé permet de réaliser des lignes se croisant sur la face 11 de la structure 10, l'isolement électrique étant réalisé entre une seconde ligne 20(b) croisant une première ligne 20(a), en passant par dessus ladite première ligne, par la première couche 21(b) isolante de la dite seconde ligne, comme illustré schématiquement en section sur la figure 4c.

Le procédé en déposant les couches successives d'une ligne permet également de suivre les formes plus ou moins complexes de la surface d'une structure, résultant de formes des pièces de la structure ou d'assemblages de pièces. La figure 4b illustre un exemple simplifié d'assemblage de deux panneaux d'une structure 10 et d'une ligne 20 cheminant sur les deux panneaux en suivant dans ce cas les contours complexes de la zone de jonction des dits deux panneaux.

Lorsqu'une ligne est réalisée, les moyens de connexion 25 de la dite ligne sont placés aux emplacements définis suivant les techniques de jonction électrique connues, brasage, projection à froid du matériau conducteur de la troisième couche ou serrage de cosses ou de bornes par exemple.

Avantageusement, pour la réalisation des lignes du réseau électrique sur la structure, il sera procédé, par plan successifs lorsque les lignes se croisent, au dépôt sur la structure de toutes les premières couches 21 des différentes lignes, puis de toutes les deuxièmes couches 22, puis de toutes les troisième couches 23 et enfin de tous les moyens de connexion 25 et autres opérations de finitions qui seraient jugées utiles ou nécessaires.

Il est ainsi optimisé la mise en oeuvre des moyens qui sont en pratique différents et spécialisés pour chacune des opérations réalisées pour aboutir à une ligne terminée.

Dans le cas de lignes se croisant, il sera avantageusement défini des strates de lignes, les lignes d'une strate ne se croisant pas entre elles et ne croisant des lignes que de seules strates auxquelles elles se superposent, la réalisation par ensemble de lignes comme présenté ci-dessus est alors réalisée strate par strate, en commençant par la strate la plus proche de la structure suivie par les strates s'empilant successivement.

Lorsque qu'une couche d'une protection isolante électrique est déposée sur les lignes réalisées, avantageusement ladite couche est déposée en finition lorsque toutes les lignes ont été formées.

Il est compris ici qu'une installation électrique dans une structure peut mettre en oeuvre seulement des lignes suivant l'invention ou des lignes suivant l'invention combinées à des lignes réalisées suivant les méthodes et les formes connues au moyen de fils, comportant une âme conductrice et un enrobage isolant, maintenus par des supports eux même fixés sur la structure.

Des lignes de l'invention et des lignes sur supports peuvent être agencées indépendamment ou être montées en série pour répondre à des contraintes spécifiques à l'installation électrique ou à la structure.

Les lignes de l'invention peuvent en cas de besoin être réparées en cas d'endommagement local de la troisième couche 23 conductrice.

En cas de perte de continuité électrique due à un endommagement 37 localisé, la ligne peut être réparée en reconstituant localement la troisième couche par une projection à froid similaire à celle mise en oeuvre pour former la troisième couche, après avoir réaliser, si besoin, un décapage de la partie endommagée.

La ligne peut également être réparée par brasage sur la troisième couche de ladite ligne d'un shunt 38 formant un pont conducteur électrique sur le défaut constaté comme dans l'exemple de la figure 4f.

La ligne peut également, dans un cas particulier où le défaut n'a pas été localisé, et en particulier en attendant de pouvoir réaliser une réparation durable, être doublée par une ligne montée sur supports, solution s'apparentant au remplacement d'une ligne dans un faisceau de lignes montées sur supports.

L'invention permet ainsi d'intégrer sur les faces d'une structure des conducteurs électriques, sans qu'il ne soit pris sensiblement dans les volumes définis par la structure, agencés pour constituer un réseau complexe de distribution de l'énergie électrique vers des équipements et pour constituer un réseau de communication de données entre des équipements. Le réseau constitué est formé après la réalisation de la structure ou de sous-ensembles d'une structure complexe et les lignes du réseau sont accessibles en cas de besoin lorsque la structure est en service pour des opérations de vérification, de réparation et de modification.

Cette possibilité est obtenue en pratique sur tout type de matériau constituant la structure et en particulier sur des matériaux conducteurs électriques, sur des matériaux isolants électriques et sur des matériaux comportant une matrice formée avec une résine organique.

L'invention simplifie la conception de l'installation électrique d'un véhicule et simplifie sa réalisation avec pour effets de diminuer le temps nécessaire au montage et aux vérifications de l'installation électrique.

Le gain de l'invention porte également sur la réduction de la masse du fait que les sur-longueurs habituelles sont évitées et que les sections conductrices peuvent être adaptées simplement pour chaque segment d'une ligne.

Le principe des lignes de l'invention écarte également le phénomène de propagation d'arc qui se rencontre entre des câbles électriques voisins mis en contact et séparés par un isolant du conducteur.

Les principes de l'invention évitent également les phénomènes d'usure des isolants de câbles électriques lorsque les dits câble frottent sur la structure.

## Revendications

1. - Procédé (240) de réalisation d'une ligne (20) électrique sur une surface d'une face (11) d'une structure (10), ledit procédé comportant la formation (243) d'une couche (23) conductrice électrique, de ladite ligne électrique, résultant d'un dépôt par un procédé de projection à froid d'un matériau conducteur électrique, entre des extrémités de ladite ligne, sur la dite face de la structure, **caractérisé en ce qu'**il comporte :
• une étape (241) de dépôt sur la structure d'une couche (21) isolante électrique suivie d'une étape (242) de projection à la flamme oxygaz d'un matériau de protection pour former une couche (22) de projection et d'accroche sur ladite couche (21), suivie d'une étape de projection à froid du matériau conducteur électrique de la couche (23) conductrice sur la dite couche (22) d'accroche, le matériau de la couche (22) étant projeté avec une vitesse comprise entre 20m/s et 100m/s, de préférence entre 25m/s et 70m/s.
• et **en ce que** le procédé comporte la réalisation d'une pluralité de lignes (20) électriques dans laquelle au moins une ligne supérieure (20(b)) croise au moins une ligne inférieure (20(a)), ladite au moins une ligne inférieure étant localement entre la structure (10) et ladite au moins une ligne supérieure, ladite au moins une ligne supérieure comportant une couche isolante (21 (b)) au moins au niveau où les lignes se croisent.

2. - Procédé suivant la revendication 1 dans lequel la couche (21) isolante est réalisée par au moins un pli d'un tissu de fibres de verre ou de fibres d'un polymère électriquement isolant maintenues dans une matrice d'un polymère organique et fixée à la structure (10).

3. - Procédé suivant l'une des revendications 1 à 2 dans lequel le matériau projeté par le procédé de projection à la flamme oxygaz pour former la couche (22) de projection et d'accroche comporte principalement du Zinc, ou un alliage à base de Zinc, ou de l'Aluminium, ou un alliage à base d'Aluminium.

4. - Procédé suivant la revendication 3 dans lequel la couche (22) de protection et d'accroche est formée avec une épaisseur comprise entre 0,05 mm et 1,5 mm.

5. - Procédé suivant l'une des revendications 3 ou 4 dans lequel, pendant l'étape de réalisation de la couche (22) de protection et d'accroche, une température de la flamme est comprise entre 200°C et 3000°C, de préférence entre 280°C et 1100°C.

6. - Procédé suivant l'une des revendications 1 à 5 dans lequel le matériau projeté à froid pour former la couche (23) conductrice électrique comporte principalement du cuivre, ou un alliage à base de cuivre, ou de l'aluminium, ou un alliage à base aluminium.

7. - Procédé suivant la revendication 6 dans lequel la projection à froid du matériau projeté est réalisée avec une température du gaz comprise entre 100°C et 1100°C, de préférence entre 200°C et 600°C, et une pression du gaz comprise entre 10 fois et 50 fois la pression atmosphérique standard, de préférence entre 18 fois et 45 fois la pression atmosphérique standard.

8. - Procédé (200) de réalisation d'un ensemble comportant une structure (10) et comportant au moins une ligne (20) électrique sur une face (11) de ladite structure comportant une étape (210) de réalisation de la structure (10), une étape (220) de définition de la position de moyens de connexion (25) à ladite au moins une ligne et de définition des performances attendues de ladite au moins une ligne, une étape (230) de définition des caractéristiques physiques de ladite au moins une ligne, puis une étape (240) de réalisation de l'au moins une ligne suivant le procédé de l'une des revendications 1 à 7.

## Patentansprüche

1. Verfahren (240) zur Herstellung einer elektrischen Leiterbahn (20) auf einer Oberfläche einer Seite (11) einer Struktur (10), wobei das Verfahrens die Bildung (243) einer elektrisch leitenden Schicht (23), der elektrischen Leiterbahn aufweist, als Ergebnis einer Abscheidung mittels eines Verfahrens zum kalten Aufspritzen eines elektrisch leitenden Materials, zwischen den Enden der Leiterbahn, auf der Seite der Struktur, **dadurch gekennzeichnet, dass** es Folgendes aufweist:
• einen Schritt (241) des Abscheidens, auf der Struktur, einer elektrisch isolierenden Schicht (21), gefolgt von einem Schritt (242) des Brenngas-Sauerstoff-Flammspritzens eines Schutzmaterials, um eine Schutz- und Haftschicht (22) auf der Schicht (21) zu bilden, gefolgt von einem Schritt des kalten Aufspritzens des elektrisch leitenden Materials der leitenden Schicht (23) auf der Haftschicht (22), wobei das Material der Schicht (22) mit einer Geschwindigkeit im Bereich von 20 m/s bis 100 m/s, vorzugsweise von 25 m/s bis 70 m/s, aufgespritzt wird,
• und dadurch, dass im Rahmen des Verfahrens eine Mehrzahl von elektrischen Leiterbahnen (20) hergestellt wird, wobei mindestens eine obere Leiterbahn (20(b)) mindestens eine untere Leiterbahn (20(a)) kreuzt, wobei sich die mindestens eine untere Leiterbahn örtlich zwischen der Struktur (10) und der mindestens einen oberen Leiterbahn befindet, wobei die mindestens eine obere Leiterbahn zumindest auf Höhe der Kreuzungsstelle der Leiterbahnen eine isolierende Schicht (21(b)) aufweist.

2. Verfahren gemäß Anspruch 1, wobei die isolierende Schicht (21) durch mindestens eine Lage eines Gewebes aus Glasfasern oder Fasern eines elektrisch isolierenden Polymers hergestellt ist, welche sich in einer Matrix aus einem organischen Polymer gehalten werden, wobei sie an der Struktur (10) befestigt ist.

3. Verfahren gemäß einem der Ansprüche 1 bis 2, wobei das Material, welches mittels des Brenngas-Sauerstoff-Flammspritzverfahren aufgespritzt wird, um die Schutz- und Haftschicht (22) zu bilden, hauptsächlich Zink, oder eine zinkbasierte Legierung, oder Aluminium, oder eine aluminiumbasierte Legierung umfasst.

4. Verfahren gemäß Anspruch 3, wobei die Schutz- und Haftschicht (22) derart gebildet wird, dass ihre Dicke im Bereich von 0,05 mm bis 1,5 mm liegt.

5. Verfahren nach einem der Ansprüche 3 oder 4, wobei die Temperatur der Flamme während des Schrittes der Herstellung der Schutz- und Haftschicht (22) im Bereich von 200 °C bis 3 000 °C, vorzugsweise von 280 °C bis 1100 °C, liegt.

6. Verfahren gemäß einem der Ansprüche 1 bis 5, wobei das Material, welches kalt aufgespritzt wird, um die elektrisch leitende Schicht (23) zu bilden, hauptsächlich Kupfer, oder eine kupferbasierte Legierung, oder Aluminium, oder eine aluminiumbasierte Legierung aufweist.

7. Verfahren gemäß Anspruch 6, wobei das kalte Aufspritzen des aufgespritzten Materials bei einer Temperatur des Gases, welche im Bereich von 100 °C bis 1100 °C, vorzugsweise von 200 °C bis 600 °C, und bei einem Druck des Gases erfolgt, welcher im Bereich des 10-fachen bis 50-fachen Atmosphärennormaldrucks, vorzugsweise des 18-fachen bis 45-fachen Atmosphärennormaldrucks, liegt.

8. Verfahren (200) zur Herstellung einer Gesamtheit, die eine Struktur (10) aufweist und mindestens eine elektrische Leiterbahn (20) auf einer Seite (11) der Struktur aufweist, wobei es einen Schritt (210) des Herstellens der Struktur (10), einen Schritt (220) des Festlegens der Position von Anschlussmitteln (25) an die mindestens eine Leiterbahn und des Festlegens der erwarteten Leistungskennwerte der mindestens einen Leiterbahn, einen Schritt (230) des Festlegens der physikalischen Eigenschaften der mindestens einen Leiterbahn, und anschließend einen Schritt (240) des Herstellens der mindestens einen Leiterbahn gemäß dem Verfahren nach einem der Ansprüche 1 bis 7 aufweist.

## Claims

1. Process (240) for producing an electrical line (20) on a surface of a face (11) of a structure (10), said process comprising the formation (243) of an electrical conductive layer (23), of said electrical line, resulting from a deposition by a cold spraying process of an electrical conductive material, between ends of said line, on said face of the structure, **characterized in that** it comprises:
• a stage (241) of deposition, on the structure, of an electrical insulating layer (21), followed by a stage (242) of oxy-gas flame spraying of a protective material in order to form a protective and tie layer (22) on said layer (21), followed by a stage of cold spraying of the electrical conductive material of the conductive layer (23) on said tie layer (22), the material of the layer (22) being sprayed with a rate of between 20 m/s and 100 m/s, preferably between 25 m/s and 70 m/s,
• and **in that** the process comprises the production of a plurality of electrical lines (20) in which at least one upper line (20 (b)) crosses at least one lower line (20(a)), said at least one lower line being locally between the structure (10) and said at least one upper line, said at least one upper line comprising an insulating layer (21(b)) at least where the lines intersect.

2. Process according to Claim 1, in which the insulating layer (21) is made of at least one ply of a fabric of glass fibres or of fibres of an electrically insulating polymer which are held in a matrix of an organic polymer and attached to the structure (10).

3. Process according to either of Claims 1 and 2, in which the material sprayed by the oxy-gas flame spraying process in order to form the protective and tie layer (22) mainly comprises zinc, or a zinc-based alloy, or aluminium, or an aluminium-based alloy.

4. Process according to Claim 3, in which the protective and tie layer (22) is formed with a thickness of between 0.05 mm and 1.5 mm.

5. Process according to either of Claims 3 and 4, in which, during the stage of producing the protective and tie layer (22), a temperature of the flame is between 200°C and 3000°C, preferably between 280°C and 1100°C.

6. Process according to one of Claims 1 to 5, in which the material cold-sprayed in order to form the electrical conductive layer (23) mainly comprises copper, or a copper-based alloy, or aluminium, or an aluminium-based alloy.

7. Process according to Claim 6, in which the cold spraying of the sprayed material is carried out with a temperature of the gas of between 100°C and 1100°C, preferably between 200°C and 600°C, and a pressure of the gas of between 10 times and 50 times standard atmospheric pressure, preferably between 18 times and 45 times standard atmospheric pressure.

8. Process (200) for producing an assembly comprising a structure (10) and comprising at least one electrical line (20) on a face (11) of said structure comprising a stage (210) of producing the structure (10), a stage (220) of definition of the position of means of connection (25) to said at least one line and of definition of the expected performance levels of said at least one line, a stage (230) of definition of the physical characteristics of said at least one line, and then a stage (240) of producing the at least one line according to the process of one of Claims 1 to 7.
